# EUROPÄISCHE PATENTSCHRIFT

(11) **EP 1 166 337 B1**
(45) Veröffentlichungstag und Bekanntmachung des Hinweises auf die Patenterteilung: **07.11.2007**
(21) Anmeldenummer: 00930992.3
(22) Anmeldetag: 24.03.2000
(51) Int. Cl.: H01L 21/00

(54) **ANLAGE ZUR FERTIGUNG VON HALBLEITERPRODUKTEN**
DEVICE FOR MANUFACTURING SEMICONDUCTOR PRODUCTS
INSTALLATION POUR FABRIQUER DES PRODUITS SEMICONDUCTEURS

(30) Priorität: 25.03.1999 DE 19913628
(43) Veröffentlichungstag der Anmeldung: 02.01.2002
(73) Patentinhaber: Qimonda AG, 81739 München (DE)
(72) Erfinder: ELGER, Jürgen, D-90602 Pyrbaum (DE)
(74) Vertreter: Epping - Hermann - Fischer
(86) Internationale Anmeldenummer: PCT/DE2000/000942
(87) Internationale Veröffentlichungsnummer: WO 2000/059003

(56) Entgegenhaltungen:
- US-A- 5 164 905
- US-A- 5 820 679

## Beschreibung

Die Erfindung betrifft eine Anlage zur Fertigung von Halbleiterprodukten gemäß dem Anspruch 1.

Derartige Anlagen können insbesondere als Anlage zu Bearbeitung von Wafern ausgebildet sein. Diese Anlagen umfassen eine Vielzahl von Fertigungseinheiten, mit welchen unterschiedliche Fertigungsprozesse durchgeführt werden. Bei diesen Fertigungsprozessen handelt es sich insbesondere um Ätzprozesse, Naßchemieverfahren, Diffusionsprozesse sowie diverse Reinigungsverfahren wie zum Beispiel CMP-Verfahren (Chemical Mechanical Polishing). Für jeden dieser Prozesse sind eine oder mehrere Fertigungseinheiten vorgesehen, in welchen verschiedene Fertigungsschritte eines Fertigungsprozesses durchgeführt werden. Außerdem wird auf folgende Dokumente Bezüg genommen: US-A-5 820 679 und US-A-5 164 905.

Zudem umfassen derartige Anlagen eine Vielzahl von Meßeinheiten. In den Meßeinheiten wird die Bearbeitungsqualität von einem oder mehreren Fertigungsschritten eines Fertigungsprozesses überprüft.

Der gesamte Fertigungsprozeß unterliegt strengen Reinheitsanforderungen, so daß die Fertigungseinheiten und Meßeinheiten in einem Reinraum oder in einem System von Reinräumen angeordnet sind.

Die Wafer werden in Kassetten in vorbestimmten Losgrößen über ein Transportsystem den einzelnen Fertigungseinheiten zugeführt. Auch der Abtransport der Kassetten nach Bearbeitung dieser Wafer erfolgt über das Transportsystem.

Das Transportsystem weist typischerweise ein Fördersystem auf, welches beispielsweise in Form von Rollenförderern aus gebildet ist. Die Kassetten mit den Wafern werden dabei auf den Rollenförderern aufliegend transportiert. Alternativ kann das Fördersystem auch aus Stetigförderern, Hängeförderern oder dergleichen bestehen.

Derartige Fördersysteme verlaufen linienförmig durch den Reinraum. Um die Zuführung der Kassetten mit den Wafern zu den Fertigungseinheiten zu gewährleisten, verzweigen die Fördersysteme in geeigneter Weise. Auf diese Weise entsteht ein mehr oder weniger geschlossenes Netzwerk von Rollenförderern innerhalb des Reinraums.

Um eine ausreichende Versorgung der Fertigungs- und Meßeinheiten mit Wafern zu gewährleisten, weist das Transportsystem zusätzlich ein Speichersystem auf, welches eine bestimmte Anzahl von Speichern aufweist, die in geeigneter Weise über den Reinraum verteilt sind. Derartige Speicher sind typischerweise als Stocker ausgebildet, welche an das Fördersystem angebunden sind. In den Stockern ist jeweils eine vorgegebene Anzahl von Kassetten mit Wafern zwischengespeichert. Je nach Bedarf werden Kassetten mit Wafern in geeigneter Anzahl aus den Stockern ausgelagert und über das Fördersystem den Fertigungs- und Meßeinheiten zugeführt.

Nachteilig hierbei ist jedoch, daß die Einlagerung der Kassetten mit Wafern in die Stocker sehr zeitaufwendig und kostenintensiv ist.

In der Veröffentlichung "What Gain from Small Batch Manufactoring", George Horn und William A. Podgorski in "Semiconductor Fabtech", 8th Edition wird eine Anlagenstruktur vorgeschlagen, mit welcher die Anzahl der Stocker vermindert werden kann.

Das dort beschriebene Transportsystem umfaßt neben einem Fördersystem mehrere lokale Prozeßpuffer. Dabei ist jeweils ein Prozeßpuffer mehreren identischen Fertigungseinheiten zugeordnet, welche jeweils dieselben Fertigungsschritte eines Fertigungsprozesses abarbeiten. Zudem sind Speicher mit größeren Speicherkapazitäten für mehrere sich zu einem Fertigungsprozeß ergänzenden Fertigungs- und Meßeinheiten vorgesehen, falls für derartige Fertigungsprozesse entsprechende Speicherkapazitäten erforderlich sind. Zu diesen Fertigungsprozessen gehören beispielsweise Diffusionsprozesse.

Zwar werden bei einer derartigen Anlage keine Stocker mehr benötigt. Jedoch ist der Zeitaufwand für die Ein- und Auslagerung der Kassetten mit den Wafern noch immer beträchtlich. Entsprechend der Bearbeitungskapazitäten der Fertigungs- und Meßeinheiten müssen Kassetten in ausreichender Anzahl in den lokalen Prozeßpuffern und in den Speichern, welche zur Versorgung der Fertigungs- und Meßeinheiten eines Fertigungsprozesses dienen, zwischengespeichert werden. Danach müssen die Kassetten wieder ausgelagert und den jeweiligen Fertigungs- und Meßeinheiten zugeordnet werden, damit sie diesen Fertigungs- und Meßeinheiten über das Fördersystem zugeführt werden können.

Der Erfindung liegt die Aufgabe zugrunde, bei einer Anlage der eingangs genannten Art eine möglichst einfache, effiziente und kostengünstige Zufuhr von Halbleiterprodukten zu den einzelnen Fertigungs- und Meßeinheiten zu schaffen.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Die erfindungsgemäße Anlage weist eine Anordnung von Bearbeitungsstationen gemäß dem Anspruch 1 auf. Jede dieser Bearbeitungsstationen weist wenigstens eine Fertigungs- oder Meßeinheit sowie einen an diese angeordneten Fertigungspuffer zur Ablage von Halbleiterprodukten auf. Zudem ist ein Handhabungsgerät vorgesehen, welches ebenfalls Bestandteil der Bearbeitungsstation ist. Mittels des Handhabungsgeräts erfolgt selbsttätig die Anlieferung und der Abtransport der Halbleiterprodukte zu dem bzw. von dem Fertigungspuffer.

Die einzelnen Bearbeitungsstationen sind über ein Fördersystem verbunden, über welches der Transport der Halbleiterprodukte zwischen den einzelnen Bearbeitungsstationen erfolgt.

Der wesentliche Vorteil der erfindungsgemäßen Analge besteht darin, daß die Halbleiterprodukte an Fertigungspuffer angeliefert werden, welche unmittelbar an den Fertigungs- oder Meßeinheiten angeordnet sind. Von den Fertigungspuffern können somit die Halbleiterprodukte direkt in die Fertigungs- oder Meßeinheiten eingespeist werden, ohne daß eine weitere Auslagerung und Zuführung über weitere Transportmittel notwendig wäre. Die Einsparung derartiger Transportmittel führt zu einer wesentlichen Kosteneinsparung. Besonders vorteilhaft ist dabei, daß in der Bearbeitungsstation keine Speichersysteme wie zum Beispiel Stocker oder lokale Prozeßpuffer vorgesehen sind, aus welchen zwischengelagerte Halbleiterprodukte entnommen, aussortiert und verschiedenen Fertigungs- oder Meßeinheiten zugeführt werden müssen. Die Halbleiterprodukte sind vielmehr auf den Fertigungspuffern bereits den jeweiligen Fertigungs- oder Meßeinheiten zugeordnet.

Die Lagerung der Halbleiterprodukte in den Fertigungspuffern führt somit durch die Einsparung von Stockern und lokalen Prozeßpuffern zu einer erheblichen Kostenersparnis und Vereinfachung des Materialflusses in der Anlage.

Ein weiterer Vorteil ist darin zu sehen, daß die Fertigungspuffer platzsparend unmittelbar an den Fertigungs- oder Meßeinheiten anbringbar sind, was zu einem geringen Flächenbedarf der Anlage führt.

Schließlich ist vorteilhaft, daß der Transport der Halbleiterprodukte innerhalb einer Bearbeitungsstation sehr schnell und ohne jeglichen Personaleinsatz erfolgen kann. Das Handhabungsgerät, welches insbesondere als Roboter oder Regalbediengerät ausgebildet sein kann, führt die von Fördersystem angelieferten Halbleiterprodukte selbsttätig den Fertigungspuffern zu und sorgt auch für deren Abtransport zum Fördersystem. Auch die Entnahme von Halbleiterprodukten aus einem Fertigungspuffer, das anschließende Einführen in die Fertigungs- oder Meßeinheit sowie die nachfolgende Entnahme erfolgt vorzugsweise mittels Roboter, Greifern oder dergleichen selbsttätig.

In einer besonders vorteilhaften Ausführungsform sind die Fertigungspuffer in Form von Regalen ausgebildet. Derartige Regale sind kostengünstig und können zudem einfach und schnell mittels eines Regalbediengeräts mit Halbleiterprodukten bestückt werden. Besonders vorteilhaft sind diese Regale unmittelbar oberhalb von Be- und Entladestationen an den jeweiligen Fertigungs- oder Meßeinheiten angeordnet.

Dies bedeutet nicht nur eine äußert platzsparende Installation des Fertigungspuffers an der jeweiligen Fertigungs- oder Meßeinheit. Vielmehr sind die Fertigungspuffer auch in unmittelbarer Nähe der Be- und Entladestation angeordnet, welche zur Zufuhr der Halbleiterprodukte in die jeweilige Fertigungs- und Meßeinheit dient. Durch diese Anordnung wird der Aufwand des Transports der Halbleiterprodukte zwischen den Be- und Entladestationen und dem Regal auf ein Minimum reduziert.

Schließlich können vorteilhafterweise die Kapazitäten der Regale an den Bedarf an Halbleiterprodukten durch eine geeignete Wahl der Größe der Regale einfach angepaßt werden. Vorteilhaft ist ferner, daß die Halbleiterprodukte nach dem Kanbanprinzip den einzelnen Regalen zuführbar sind. Unterschreitet der Befüllungsgrad eines Regals einen vorgegebenen Sollwert, wird das Regal durch das Regalbediengerät mit einer vorgegebenen Anzahl von Halbleiterprodukten neu bestückt.

Die Erfindung wird im nachstehenden anhand der Zeichnungen erläutert. Es zeigen:
- Figur 1:: Schematische Darstellung einer Anlage zur Fertigung von Halbleiterprodukten mit einer Anordnung von Bearbeitungsstationen.
- Figur 2:: Schematische Darstellung eines Ausführungsbeispiels einer Bearbeitungsstation für die Anlage gemäß Figur 1.

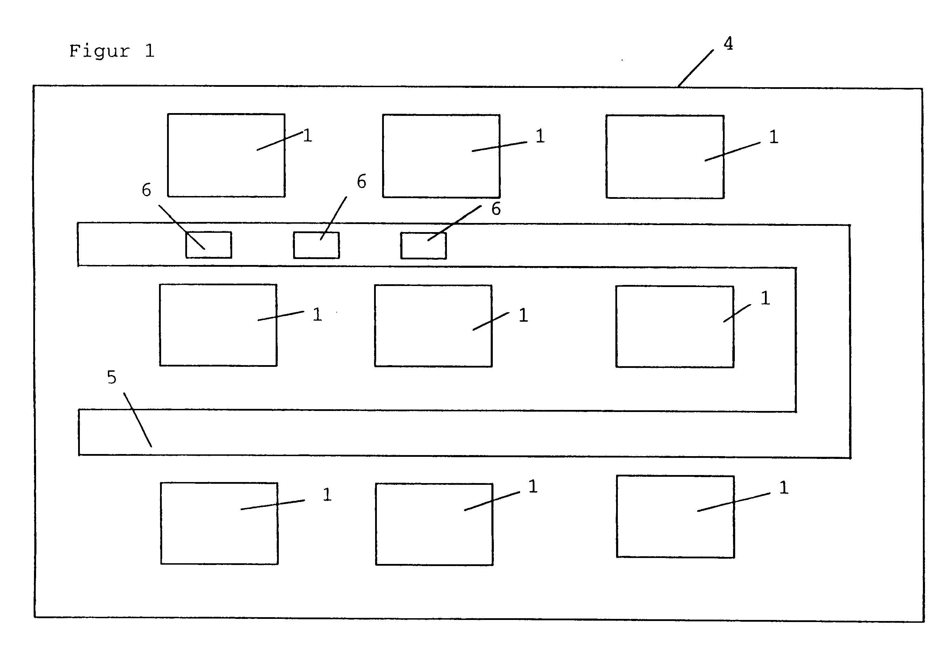

In Figur 1 ist schematisch eine Anlage zur Fertigung von Halbleiterprodukten dargestellt, wobei es sich im vorliegenden Ausführungsbeispiel um eine Anlage zur Bearbeitung von Wafern handelt.

Die Anlage weist eine Vielzahl von Bearbeitungsstationen 1 auf, wobei in einer Bearbeitungsstation 1 eine oder mehrere Fertigungseinheiten 2 oder Meßeinheiten 3 vorgesehen sind. Die Fertigungseinheiten 2 dienen zur Durchführung unterschiedlicher Fertigungsschritte bei den für die Bearbeitung der Wafer erforderlichen Fertigungsprozessen. Diese Fertigungsprozesse umfassen insbesondere Ätzprozesse, Naßchemieverfahren, Diffusionsprozesse sowie Reinigungsverfahren. Für die einzelnen Fertigungsprozesse können entsprechend der Anzahl der durchzuführenden Fertigungsschritte eine oder mehrere Fertigungseinheiten 2 vorgesehen sein.

Die Meßeinheiten 3 dienen zur Überprüfung der Bearbeitungsqualität der in den einzelnen Fertigungseinheiten 2 durchgeführten Fertigungsschritte.

Die Bearbeitungsstationen 1 mit den einzelnen Fertigungseinheiten 2 und Meßeinheiten 3 sind in einem Reinraum 4 angeordnet und über die Transportsystem miteinander verbunden. Alternativ können die Bearbeitungsstationen 1 über ein System von Reinräumen 4 verteilt sein.

Das Transportsystem weist ein Fördersystem 5 auf, welches die Wafer den einzelnen Bearbeitungsstationen 1 zuführt. Die Wafer werden dabei in bestimmten Losgrößen in Kassetten 6 transportiert. Das Fördersystem 5 kann in Form von Rollenförderern, Stetigförderern oder dergleichen ausgebildet sein. Das Transportsystem kann zudem ein nicht dargestelltes Speichersystem aufweisen, welches mehrere im Reinraum 4 verteilte Speicher umfaßt. Diese Speicher können insbesondere von Stockern gebildet sein. In diesen Speichern werden Kassetten 6 mit Wafern zwischengelagert. Beispielsweise können dort Kassetten 6 zwischengelagert werden, welche Wafer enthalten, die in den einzelnen Fertigungseinheiten 2 fehlerhaft bearbeitet wurden. Zu geeigneten Zeitpunkten werden diese zur Nacharbeit aus den Speichern ausgelagert und bestimmten Fertigungseinheiten 2 zugeführt.

In einer besonders vorteilhaften Ausführungsform ist die Speicherkapazität der Bearbeitungsstationen 1 und des Fördersystems 5 so ausgelegt, daß auf das Speichersystem verzichtet werden kann.

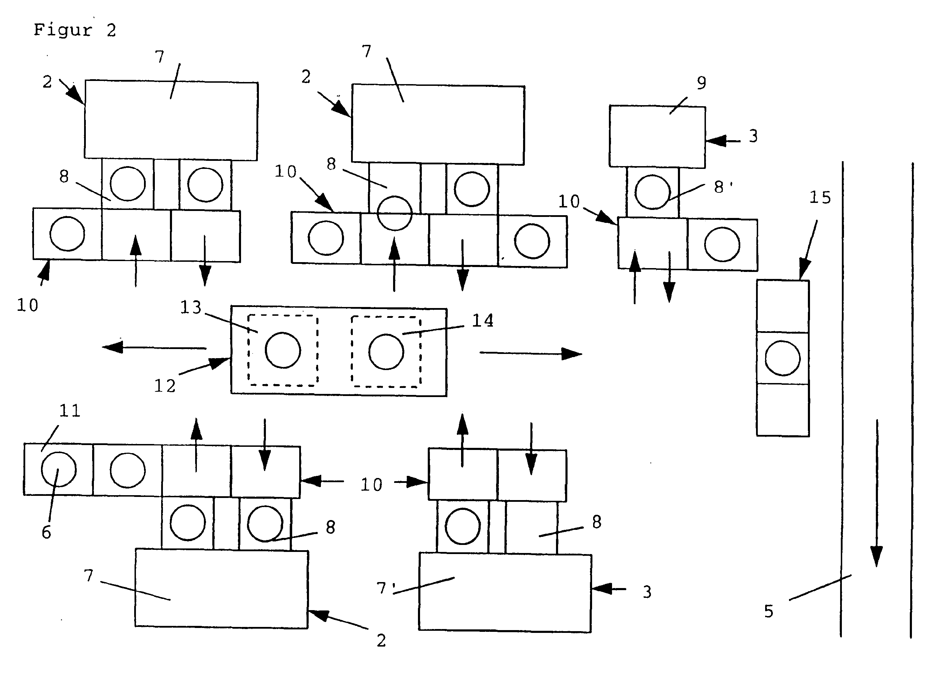

Die einzelnen Bearbeitungsstationen 1 weisen, wie insbesondere aus Figur 2 ersichtlich ist, jeweils wenigstens eine Fertigungs- 2 oder Meßeinheit 3 auf, wobei an dieser ein Fertigungspuffer angeordnet ist. Die Fertigungspuffer dienen zur Ablage von Kassetten 6 mit Wafern. Diese Kassetten 6 werden mittels eines Handhabungsgeräts selbsttätig vom Fördersystem 5 dem jeweiligen Fertigungspuffer zugeführt. Je nach Bedarf werden vom Fertigungspuffer Kassetten 6 mit Wafern entnommen und in die Fertigungs- 2 oder Meßeinheit 3 zur Bearbeitung eingeführt. Nach erfolgter Bearbeitung wird die Kassette 6 aus der Fertigungs- 2 oder Meßeinheit 3 entnommen und auf dem Fertigungspuffer abgelegt. Von dort entnimmt das Handhabungsgerät zu geeigneten Zeitpunkten Kassetten 6 mit bearbeiteten Wafern und führt sie dem Fördersystem 5 zu.

Figur 2 zeigt ein Ausführungsbeispiel einer derartigen Bearbeitungsstation 1. Diese Bearbeitungsstation 1 weist mehrere Fertigungs- 2 und Meßeinheiten 3 auf. In diesen Fertigungs- 2 und Meßeinheiten 3 wird ein kompletter Fertigungsprozeß durchgeführt. Bei diesem Fertigungsprozeß kann es sich beispielsweise um einen Lithographieprozeß handeln. Die Fertigungseinheiten 2 bestehen vorzugsweise im wesentlichen aus Maschinen 7 mit jeweils eine Be- und Entladestation 8 für die Zufuhr und den Abtransport der Wafer, wobei die unterschiedlichen Fertigungseinheiten 2 zum Aufbringen von Photolack auf die Wafer, zur Belichtung des Photolacks und zum Entwickeln des Photolacks dienen.

In einer der Meßeinheiten 3 wird überprüft, ob die Mehrfachschichten, welche in den einzelnen Wafern vorhanden sind, korrekt übereinanderliegen. In einer anderen Meßeinheit 3 wird optisch geprüft, ob die Wafer Verwerfungen aufweisen. Die erste Meßeinheit 3 ist vorzugsweise von einer Maschine 7' gebildet, welche wiederum eine Be- und Entladestation 8 aufweist. Die zweite Meßeinheit 3 ist im vorliegenden Ausführungsbeispiel von einem personellen Arbeitsplatz 9 gebildet. Dieser Arbeitsplatz 9 weist eine vereinfachte Be- und Entladestation 8' in Form einer Stellfläche auf. Am Arbeitsplatz 9 überprüft das Bedienpersonal, ob die Bearbeitung der Wafer korrekt erfolgt ist. Alternativ können sämtliche Meßeinheiten 3 als Maschinen 7' gebildet sein. Dann erfolgt die Bearbeitung der Wafer in der Bearbeitungsstation 1 ohne jeglichen Personaleinsatz.

An den jeweiligen Fertigungs- 2 und Meßeinheiten 3 der Bearbeitungsstation 1 ist jeweils ein als Regal 10 ausgebildeter Fertigungspuffer vorgesehen. Jedes der Regale 10 weist eine vorgegebene Anzahl von Regalfächern 11 auf. Je nach Bearbeitungskapazität der einzelnen Fertigungs- 2 und Meßeinheiten 3 können die diesen zugeordneten Regale 10 eine unterschiedlichen Anzahl von Regalfächern 11 aufweisen. Die Regale 10 sind jeweils an den Be- und Entladestationen 8, 8' der Fertigungs-2 und Meßeinheiten 3 angeordnet. Über diese Be- und Entladestationen 8, 8' werden Kassetten 6 mit Wafern in die jeweilige Fertigungs- 2 oder Meßeinheit 3 eingeführt bzw. aus dieser entnommen.

In einer vorteilhaften nicht dargestellten Ausführungsform ist das Regal 10 an der Frontwand der Fertigungs- 2 oder Meßeinheit 3 direkt oberhalb der Be- und Entladestation 8, 8' befestigt. In diesem Fall werden die Regalfächer 11 über die offene Frontseite des Regals 10 mit Kassetten 6 be- und entladen.

Bei dem in Figur 2 dargestellten Ausführungsbeispiel sind freistehende Regale 10 vorgesehen, welche jeweils eine offene Front- und Rückwand aufweisen.

Die Regale 10 sind unmittelbar vor den Be- und Entladestationen 8, 8' der Fertigungs- 2 und Meßeinheiten 3 angeordnet. Prinzipiell können sich die Regale 10 benachbarter Fertigungs- 2 und Meßeinheiten 3 auch zu einer Regalwand ergänzen. Von der Rückseite eines Regals 10 werden Kassetten 6 mit Wafern aus dem Regal 10 entnommen und der zugeordneten Fertigungs- 2 oder Meßeinheit 3 zugeführt. Nach der Bearbeitung werden die Kassetten 6 dementsprechend wieder auf Regalfächern 11 der Regale 10 abgestellt. Diese Vorgänge können prinzipiell manuell erfolgen. Im vorliegenden Ausführungsbeispiel erfolgen diese Be- und Entladevorgänge automatisiert mittels Greifern, Robotern oder dergleichen.

Um eine eindeutige Zuordnung der Kassetten 6 zu gewährleisten, sind jeweils bestimmte Regalfächer 11 für Kassetten 6 vorgesehen , welche der jeweiligen Fertigungs- 2 oder Meßeinheit 3 zugeführt werden sollen. Andere Regalfächer 11 sind für Kassetten 6 vorgesehen, welche von der Fertigungs- 2 oder Meßeinheit 3 abtransportiert werden sollen. Vorteilhafterweise sind die entsprechenden Regalfächer 11 auch unterschiedlich gekennzeichnet. Dabei sind entsprechend des Durchsatzes, der mit einer Fertigungs- 2 oder Meßeinheit 3 erzielt wird, Regalfächer 11 in entsprechender Anzahl für die Zufuhr und den Abtransport vorgesehen.

Das Handhabungsgerät, welches den Transport der Kassetten 6 vom Fördersystem 5 zu den Regalen 10 sowie deren Abtransport übernimmt, ist im vorliegenden Ausführungsbeispiel von einem Regalbediengerät 12 gebildet. Anstelle dessen könnte prinzipiell auch ein Roboter als Handhabungsgerät vorgesehen sein.

Die Fertigungs- 2 und Meßeinheiten 3 mit den davor angeordneten Regalen 10 sind dabei in zwei parallel verlaufenden Reihen angeordnet, so daß das Regalbediengerät 12 längs des Ganges zwischen den Fertigungs- 2 und Meßeinheiten 3 verfahrbar ist. Die Breite des Ganges ist an die Breite des Regalbediengeräts 12 angepaßt. Dadurch wird erreicht, daß das Regalbediengerät 12 nur längs einer geraden Bahn verfahren werden muß, um sämtliche Fertigungs- 2 und Meßeinheiten 3 anzusteuern. Bei dem Regalbediengerät 12 handelt es sich um ein fahrerloses Transportfahrzeug, welches schienengebunden oder freiverfahrbar in der Bearbeitungsstation 1 verfahrbar ist.

Das Regalbediengerät 12 weist zwei separate Abstellflächen 13, 14 auf, auf welchen Kassetten 6 mit Wafern abgelegt werden können. Prinzipiell können auch mehrere Abstellflächen 13, 14 vorgesehen sein. Auf der ersten Abstellfläche 13 werden Kassetten 6 abgestellt, welche einem Regal 10 an einer Fertigungs- 2 oder Meßeinheit 3 zugeführt werden sollen. Die zweite Abstellfläche 14 dient zur Aufnahme von Kassetten 6 des entsprechenden Regals 10.

Dadurch wird erreicht, daß bei vor einem Regal 10 positionierten Regalbediengerät 12 sowohl Kassetten 6 mit Wafern vom Regalbediengerät 12 abgenommen auf dem Regal 10 abgelegt werden können als auch Kassetten 6 mit Wafern vom Regal 10 aufgenommen werden können. Zur Durchführung dieser Be- und Entladevorgänge ist am Regalbediengerät 12 ein nicht dargestellter Greifer vorgesehen.

Die Positionierung des Regalbediengeräts 12 an den Regalen 10 der einzelnen Fertigungs- 2 und Meßeinheiten 3 erfolgt zweckmäßigerweise über eine Steuerung im Regalbediengerät 12. Dabei sind zweckmäßigerweise die Anfahrpositionen der Fertigungs- 2 und Meßeinheiten 3 in der Steuerung als Parameterwerte abgespeichert. Durch Änderung dieser Parameterwerte kann der Verfahrweg des Regalbediengeräts 12 einfach und schnell an eine eventuelle Veränderung des Aufbaus der Bearbeitungsstation 1 angepaßt werden.

Über die Steuerung des Regalbediengeräts 12 kann auch auf einfache Weise eine Füllstandsregelung der Regale 10 nach dem Kanbanprinzip vorgenommen werden. Unterschreitet die Befüllung einzelner Regale 10 einen vorgegebenen Sollwert, so wird durch das Regalbediengerät 12 eine bestimmte Anzahl von Kassetten 6 im Regal 10 nachgefüllt.

Das Regalbediengerät 12 bildet die Verbindung zwischen dem Fördersystem 5 der Anlage und den Fertigungseinheiten 2 und Meßeinheiten 3 einer Bearbeitungsstation 1. Im einfachsten Fall werden vom Regalbediengerät 12 Kassetten 6 mit Wafern unmittelbar vom Fördersystem 5 aufgenommen und wieder auf dem Fördersystem 5 zugeführt.

Bei dem in Figur 2 dargestellten Ausführungsbeispiel ist am Ausgang der Bearbeitungsstation 1 unmittelbar vor dem Fördersystem 5 eine von einem Regal 10 gebildete Übergabestation 15 vorgesehen. Analog zu den Regalen 10 der Fertigungs- 2 und Meßeinheiten 3 werden vom Fördersystem 5 Kassetten 6 mittels eines nicht dargestellten Greifers abgenommen und in entsprechend gekennzeichneten Regalfächern 11 der Übergabestation 15 abgelegt. In anderen, ebenfalls gekennzeichneten Regalfächern 11 sind Kassetten 6 abgelegt, die in der Bearbeitungsstation 1 bearbeitet worden sind. Von diesen Regalfächern 11 werden mittels der Greifer die Kassetten 6 wieder dem Fördersystem 5 zugeführt. Das Regalbediengerät 12 ist an der Rückseite der Übergabestation 15 positionierbar, um von dieser Kassetten 6 zu entnehmen, die in der Bearbeitungsstation 1 zu bearbeiten sind. Entsprechend werden mittels des Regalbediengeräts 12 in den hierfür vorgesehenen Regalfächern 11 der Übergabestation 15 Kassetten 6 mit bearbeiteten Wafern abgelegt.

## Patentansprüche

1. Anlage zur Fertigung von Halbleiterprodukten, insbesondere von Wafern, mit mehreren Fertigungseinheiten und Meßeinheiten in wenigstens einem Reinraum, wobei in dem Reinraum (4) eine Anordnung von Bearbeitungsstationen (1) vorgesehen ist, welche jeweils wenigstens eine Fertigungs- (2) oder Meßeinheit (3) und einen Fertigungspuffer zur Ablage von Halbleiterprodukten sowie ein Handhabungsgerät zum selbsttätigen Anliefern und Abtransportieren der Halbleiterprodukte zu bzw. von dem Fertigungspuffer aufweist, wobei die Bearbeitungsstationen (1) über ein Fördersystem (5) miteinander verbunden sind,
**dadurch gekennzeichnet, daß**
die Fertigungspuffer unmittelbar an den Fertigungs- (2) oder Meßeinheiten (3) angeordnet sind.

2. Anlage nach Anspruch 1,
**dadurch gekennzeichnet, daß**
der Fertigungspuffer von einem Regal (10) mit mehreren Regalfächern (11) gebildet ist.

3. Anlage nach Anspruch 2, **dadurch gekennzeichnet, daß** eine Fertigungs- (2) oder Meßeinheit (3) eine Be- und Entladestation (8) aufweist, und daß das Regal (10) unmittelbar vor der Be- und Entladestation (8) angeordnet ist.

4. Anlage nach Anspruch 3, **dadurch gekennzeichnet, daß** das Regal (10) oberhalb einer Be- und Entladestation (8) einer Fertigungs- (2) oder Meßeinheit (3) angeordnet ist.

5. Anlage nach einem der Ansprüche 2 - 4, **dadurch gekennzeichnet, daß** die Halbleiterprodukte in Kassetten (6) transportiert werden, wobei jeweils separate Regalfächer (11) für die Zufuhr und den Abtransport der Kassetten (6) vorgesehen sind.

6. Anlage nach Anspruch 5, **dadurch gekennzeichnet, daß** die Regalfächer (11) entsprechend ihrer Funktionen **gekennzeichnet** sind.

7. Anlage nach Anspruch 6, **dadurch gekennzeichnet, daß** entsprechend der Bearbeitungskapazität einer Fertigungseinheit (2) oder Meßeinheit (3) bei dem zugeordneten Regal (10) auf einer vorgegebenen Anzahl von Regalfächern (11) Kassetten (6) mit Halbleiterprodukten für den Abtransport von der zugeordneten Fertigungs- (2) oder Meßeinheit (3) bereitgestellt sind, und daß auf einer vorgegebenen Anzahl von Regalfächern (11) vom Handhabungsgerät angelieferte Kassetten (6) mit Halbleiterprodukten ablegbar sind.

8. Anlage nach einem der Ansprüche 1 - 7, **dadurch gekennzeichnet, daß** das Handhabungsgerät von einem Regalbediengerät (12) gebildet ist.

9. Anlage nach Anspruch 8, **dadurch gekennzeichnet, daß** das Regalbediengerät (12) wenigstens zwei Abstellflächen (13, 14) aufweist, wobei auf einer Abstellfläche (13) Kassetten (6) mit Halbleiterprodukten für die Zufuhr zu einem Fertigungspuffer abstellbar sind und wobei auf einer Abstellfläche (14) Kassetten (6) mit Halbleiterprodukten für den Abtransport von einer Fertigungseinheit (2) abstellbar sind.

10. Anlage nach einem der Ansprüche 8 oder 9, **dadurch gekennzeichnet, daß** das Regalbediengerät (12) Greifer aufweist, mit welchem die Kassetten (6) mit Halbleiterprodukten einem Fertigungspuffer zuführbar sind und von diesem entnehmbar sind.

11. Anlage nach einem der Ansprüche 8 - 10, **dadurch gekennzeichnet, daß** die Anfahrpositionen der Fertigungs-(2) und Meßeinheiten (3) einer Bearbeitungsstation (1) in dem Regalbediengerät (12) dieser Bearbeitungsstation (1) als Parameterwerte abgespeichert sind.

12. Anlage nach einem der Ansprüche 1 - 11, **dadurch gekennzeichnet, daß** in einer Bearbeitungsstation (1) mehrere Fertigungs- (2) und Meßeinheiten (3) zur Durchführung eines Fertigungsprozesses angeordnet sind.

13. Anlage nach Anspruch 12, **dadurch gekennzeichnet, daß** die Fertigungs- (2) und Meßeinheiten (3) jeweils von Maschinen (7) und / oder personellen Arbeitsplätzen (9) gebildet sind.

14. Anlage nach einem der Ansprüche 1 - 13, **dadurch gekennzeichnet, daß** eine Füllstandsregelung für die Fertigungspuffer vorgesehen ist, indem eine Nachfüllung des Fertigungspuffers erfolgt, sobald der Befüllungsgrad eines Fertigungspuffers einen vorgegebenen Sollwert unterschreitet.

15. Anlage nach einem der Ansprüche 1 - 14, **dadurch gekennzeichnet, daß** wenigstens ein Fertigungspuffer als Übergabestation (15) von Halbleiterprodukten zum bidirektionalen Austausch von Halbleiterprodukten mit dem Fördersystem (5) vorgesehen ist.

16. Anlage nach Anspruch 15, **dadurch gekennzeichnet, daß** der die Übergabestation (15) bildende Fertigungspuffer von einem Regal (10) gebildet ist, welches eine vorgegebene Anzahl von Regalfächern (11) aufweist, die für das Handhabungsgerät der Bearbeitungsstation (1) zugänglich sind und über welche der Ab- und Antransport von Halbleiterprodukten zum Fördersystem (5) erfolgt.

## Claims

1. Plant for producing semiconductor products, in particular wafers, having a plurality of production units and measuring units in at least one clean room, an arrangement of processing stations (1) being provided in the clean room (4), in each case having at least one production unit (2) or measuring unit (3) and a production buffer for the storage of semiconductor products, and also a handling device for the automatic delivery and outward transport of the semiconductor products to and from the production buffer, the processing stations (1) being interconnected via a conveyor system (5), **characterized in that** the production buffers are arranged directly at the production units (2) or measuring units (3).

2. Plant according to Claim 1, **characterized in that** the production buffer is formed by a storage rack (10) having a plurality of rack compartments (11).

3. Plant according to Claim 2, **characterized in that** a production unit (2) or measuring unit (3) has a loading and unloading station (8), and **in that** the storage rack (10) is arranged immediately in front of the loading and unloading station (8).

4. Plant according to Claim 3, **characterized in that** the storage rack (10) is arranged above a loading and unloading station (8) of a production unit (2) or measuring unit (3).

5. Plant according to one of Claims 2 - 4, **characterized in that** the semiconductor products are transported in cassettes (6), in each case separate rack compartments (11) being provided for the supply and the outward transport of the cassettes (6).

6. Plant according to Claim 5, **characterized in that** the rack compartments (11) are identified in accordance with their functions.

7. Plant according to Claim 6, **characterized in that**, depending on the processing capacity of a production unit (2) or measuring unit (3), cassettes (6) with semiconductor products for the outward transport from the associated production unit (2) or measuring unit (3) are provided in the associated storage rack (10) on a predefined number of rack compartments (11), and **in that** cassettes (6) with semiconductor products delivered by the handling device can be deposited on a predefined number of rack compartments (11).

8. Plant according to one of Claims 1 - 7, **characterized in that** the handling device is formed by a rack server (12).

9. Plant according to Claim 8, **characterized in that** the rack server (12) has at least two set-down surfaces (13, 14), it being possible for cassettes (6) with semiconductor products to be supplied to a production buffer to be set down on one set-down surface (13) and for cassettes (6) with semiconductor products for outward transport from a production unit (2) to be set down on a set-down surface (14).

10. Plant according to either of Claims 8 and 9, **characterized in that** the rack server (12) has grippers with which the cassettes (6) with semiconductor products can be supplied to a production buffer and removed from the latter.

11. Plant according to one of Claims 8 - 10, **characterized in that** the drive-to positions of the production units (2) and measuring units (3) of a processing station (1) are stored as parameter values in the rack server (12) belonging to this processing station (1).

12. Plant according to one of Claims 1 - 11, **characterized in that** a plurality of production units (2) and measuring units (3) for carrying out a production process are arranged in a processing station (1).

13. Plant according to Claim 12, **characterized in that** the production units (20 and measuring units (3) are each formed by machines (7) and/or staff workplaces (9).

14. Plant according to one of Claims 1 - 13, **characterized in that** level control for the production buffers is provided, by the production buffer being refilled as soon as the filling level of a production buffer falls below a predefined desired value.

15. Plant according to one of Claims 1 - 14, **characterized in that** at least one production buffer is provided as a transfer station (15) for semiconductor products for the bidirectional exchange of semiconductor products with the conveyor system (5).

16. Plant according to Claim 15, **characterized in that** the production buffer forming the transfer station (15) is formed by a storage rack (10) which has a predefined number of rack compartments (11), which are accessible to the handling device of the processing station (1) and via which semiconductor products are transported from and to the conveyor system (5).

## Revendications

1. Installation de fabrication de produits semi-conducteurs, notamment de plaquettes, lequel système comporte plusieurs unités de fabrication et unités de mesure situées dans au moins une salle blanche, un ensemble de postes de traitement (1) étant prévu dans la salle blanche (4) et comportant chacun au moins une unité de fabrication (2) ou de mesure (3) et un tampon de fabrication destiné à stocker des produits semi-conducteurs ainsi qu'un appareil de manipulation destiné à apporter automatiquement les produits semi-conducteurs au tampon de fabrication et à les emporter, les postes de traitement étant reliés entre eux par un système de convoyage (5),
**caractérisée en ce que** les tampons de fabrication sont placés directement sur les unités de fabrication (2) ou de mesure (3).

2. Installation selon la revendication 1, **caractérisé en ce que** le tampon de fabrication est formé par une étagère (10) comportant plusieurs compartiments d'étagère (11).

3. Installation selon la revendication 2, **caractérisée en ce qu'**une unité de fabrication (2) ou de mesure (3) comporte une poste de chargement et de déchargement (8), et **en ce que** l'étagère (10) est disposé directement devant la poste de chargement et de déchargement (8).

4. Installation selon la revendication 3, **caractérisée en ce que** l'étagère (10) est placée au-dessus d'un poste de chargement et de déchargement (8) d'une unité de fabrication (2) ou de mesure (3).

5. Installation selon l'une des revendications 2 à 4, **caractérisée en ce que** les produits semi-conducteurs sont transportés dans des cassettes (6), des compartiments d'étagère séparés (11) étant destinés à apporter et à emporter les cassettes (6).

6. Installation selon la revendication 5, **caractérisé en ce que** les compartiments d'étagère (11) sont identifiés selon leur fonction.

7. Installation selon la revendication 6, **caractérisée en ce que**, en fonction de la capacité de traitement d'une unité de fabrication (2) ou de mesure (3), des cassettes (6) dotées de produits semi-conducteurs sont placés dans l'étagère associée (10), sur un nombre prescrit de compartiments d'étagère (11), afin d'être enlevées de l'unité associée de fabrication (2) ou de mesure (3), et **en ce que** des cassettes (6) dotées de produits semi-conducteurs, amenées par l'appareil de manipulation, peuvent être stockées dans un nombre prescrit de compartiments d'étagère (11).

8. Installation selon l'une des revendications 7, **caractérisée en ce que** l'appareil de manipulation est formé par un gerbeur (12).

9. Installation selon la revendication 8, **caractérisée en ce que** le gerbeur (12) comporte au moins deux surfaces de stockage (13, 14), des cassettes (6) dotées de produits semi-conducteurs pouvant être stockées sur une surface de stockage (13) afin d'être amenées à un tampon de fabrication et des cassettes (6) de produits semi-conducteurs pouvant être stockées sur une surface de stockage (14) afin d'être retirées d'une unité de fabrication (2).

10. Installation selon l'une des revendications 8 ou 9, **caractérisée en ce que** le gerbeur (12) comporte des dispositifs de préhension permettant d'amener les cassettes (6) dotées de produits semi-conducteurs à un tampon de fabrication et de les retirer de celui-ci.

11. Installation selon l'une des revendications 8 à 10, **caractérisée en ce que** les positions d'approche des unités de fabrication (2) et de mesure (3) d'une poste de traitement (1) sont stockées sous forme de valeurs de paramètres dans le gerbeur (12) de cette poste de traitement (1).

12. Installation selon l'une des revendications 11, **caractérisée en ce que** plusieurs unités de fabrication (2) et de mesure (3) sont disposées dans une poste de traitement (1) afin d'effectuer un processus de fabrication.

13. Installation selon la revendication 12, **caractérisée en ce que** les unités de fabrication (2) et de mesure (3) sont formées chacune de machines (7) et de postes de travail d'opérateur (9).

14. Installation selon l'une des revendications 1 à 13, **caractérisée en ce qu'**il est prévu une régulation du remplissage des tampons de fabrication dans laquelle on poursuit le remplissage du tampon de fabrication dès que le niveau de remplissage d'un tampon de fabrication se situe au-dessous d'une valeur de consigne prescrite.

15. Installation selon l'une des revendications 1 à 14, **caractérisée en ce qu'**il est prévu au moins un tampon de fabrication conformé en poste (15) de transfert de produits semi-conducteurs en vue d'un échange bidirectionnel de produits semi-conducteurs avec le système de convoyage (5).

16. Installation selon la revendication 15, **caractérisée en ce que** le tampon de fabrication formant la poste transfert (15) est formé par une étagère (10) qui comporte un nombre prescrit de compartiments d'étagère (11) qui sont accessibles à l'appareil de manipulation du poste de traitement (1) et par lesquels s'effectuent l'enlèvement et l'apport des produits semi-conducteurs vers le système de convoyage (5).
